# EUROPÄISCHE PATENTSCHRIFT

(11) **EP 2 351 870 B1**
(45) Veröffentlichungstag und Bekanntmachung des Hinweises auf die Patenterteilung: **08.08.2018**
(21) Anmeldenummer: 11163810.2
(22) Anmeldetag: 30.05.2008
(51) Int. Cl.: C23C 14/00, C23C 14/06

(54) **Schichtsystem zur Bildung einer Oberflächenschicht auf einer Oberfläche eines Substrats**
Layer system for creating a surface layer on a surface of a substrate
Système de couche destiné à la formation d'une couche superficielle à la surface d'un substrat

(30) Priorität: 25.06.2007 EP 07110937
(43) Veröffentlichungstag der Anmeldung: 03.08.2011
(62) Teilanmeldung aus: 08157307.3
(73) Patentinhaber: Oerlikon Surface Solutions AG, Pfäffikon, 8808 Pfäffikon SZ (CH)
(72) Erfinder: Vetter, Jörg, Dr., 51469 Bergisch Gladbach (DE); Erkens, Georg, Dr., 52070 Aachen (DE)
(74) Vertreter: Intellectual Property Services GmbH

(56) Entgegenhaltungen:
- EP-A1- 1 783 245
- WO-A1-2005/100635
- JP-A- 2000 326 108
- US-A1- 2005 201 921
- US-A1- 2006 154 108

## Beschreibung

Die Erfindung betrifft eine Schichtsystem zur Bildung einer Oberfläche auf einem Substrat, eine Verdampfungsquelle zur Herstellung eines Schichtsystems, sowie ein Substrat, insbesondere ein Werkzeug mit einem erfindungsgemässen Schichtsystem gemäss dem Oberbegriff des unabhängigen Anspruchs der jeweiligen Kategorie.

Die Herstellung leistungsfähiger Werkzeuge und Bauteile wird meistens durch eine Beschichtung von deren Oberflächen realisiert. Eine wichtige Klasse solcher beschichteten Substrate sind Werkzeuge, neben anderen insbesondere zerspanende Werkzeuge sowie Bauteile, vor allem Verschleissteile für Maschinen in allen möglichen Ausführungsformen. Typische Substratmaterialien, die beschichtet werden, sind unter anderem Werkzeugstähle und Hartmetalle, aber auch alle möglichen anderen Substratmaterialien.

Entsprechende Substrate bzw. Beschichtungen sind beispielweise in der JP 2000 326 108 A, der WO 2005/100 635 A1 oder der EP 1 783 245 A1, die sämtlich Hartbeschichtungen beschreiben, die insbesondere zur Veredelung von Werkzeugen geeignet sind.

Ein bekanntes Problem beim Beschichten dieser Werkstoffe ist dabei, dass beide eine hohe Oxidationsrate an Luft bereits um 500 °C aufweisen und bereits bei relativ niedrigen Temperaturen (ca. HSS 550 °C, Hartmetall 650°C) erweichen.

Daher kommen insbesondere für die Hartbearbeitung von Stählen bevorzugt auch keramische Schneidkörper, z.B. auf der Basis von kubischem Bornitrid zum Einsatz. So werden zum Beispiel zur Hochgeschwindigkeitsbearbeitung von AI-Legierungen und Grauguß vermehrt verschiedenste SiN-Keramiken eingesetzt. Die Keramiken erweisen sich dabei als wesentlich beständiger gegenüber den metallischen Werkzeugmaterialien. Eine weitere Leistungssteigerung kann durch geeignete Beschichtung der Werkzeuge erreicht werden.

Die aus dem Stand der Technik bekannten Hartstoffschichten basieren dabei häufig auf klassischen Verbindungen wie TiN, TiNC, CrN. Diese bekannten Hartschichten haben in Bezug auf ihren Einsatzbereich aufgrund ihrer speziellen physikalischen Eigenschaften jedoch ihre Grenzen, vor allem bezüglich der Temperaturbelastbarkeit. Einerseits sinkt nämlich die Härte bei erhöhten Temperaturen merklich ab, andererseits setzt bereits bei relativ niedrigen Temperaturen eine Oxidation ein, die zu erhöhtem Schichtverschleiß bei der Einsatztemperatur führen kann.

Um diese Probleme zu umgehen wurden im wesentlichen zwei Schichtklassen entwickelt, die eine Oxidationsbeständigkeit im Bereich bis zu 1000 °C aufweisen und auch bezüglich der Härte verbesserte Eigenschaften haben.

Die eine Schichtklasse betrifft Al-haltige Basisschichten wie AlTiN und AlCrN, wobei, je nach Anforderung zusätzliche Elemente hinzulegiert werden können. Typische Verbindungen aus diesem Bereich sind Verbindungen der Form AlTiXNCO, wobei X z.B. Cr oder ein anderes Metall ist.

Ein anderer im Stand der Technik beschrittener Weg zur Leistungssteigerung beschichteter Werkzeuge besteht in der Kombination von klassischen Hartstoffschichten als Trägerschicht kombiniert mit Finish-Schichten als Funktionsschicht. Insbesondere sind hier als Finish-Schichten die hoch Sihaltigen Schichten (10 at% oder mehr; at% bedeutet dabei im Rahmen dieser Anmeldung "Atomprozent") des Typs MeSiXNCO-Schicht (X weitere Metalle oder B) wie TiSiN zu nennen, die eine deutlich verbesserte Temperaturbelastung ermöglichen.

Daneben ist es weiterhin beispielsweise bekannt, oxidische Keramikschichen wie Al₂O₃ mittels CVD-Verfahren auf Wendeschneidplatten abzuscheiden, um den Verschleißprozessen bei erhöhten Kontakttemperaturen, insbesondere beim Drehen begegnen zu können.

Im Stadium der Erforschungen sind darüber hinaus Bor-basierte Schichten, wie zum Beispiel B₄C oder auch kubische BN Schichten. Allerdings hat kubisches BN den entscheidenden Nachteil, dass es äußert kompliziert darstellbar ist. Dies ist vor allem durch Schwierigkeiten beim Schichtwachstum selbst, aber auch durch die hohen Eigenspannungen in den Schichten bedingt.

Im Bereich der Hochtemperaturwerkstoffe wurden in den letzten Jahren Volumenkeramiken auf der Basis von SiCN erzeugt, die sich durch hohe Härten und eine Verbesserung der Oxidationsbeständigkeit gegenüber SiC und Si₃N₄ auszeichnen. Deren besondere Eigenschaften sind durch die komplexen kovalenten chemischen Bindungen und die niedrige Diffusionsrate von Sauerstoff in der amorphen Struktur des SiCN begründet.

Allen bisherigen Bemühungen zum Trotz ist es aber nur teilweise gelungen, Beschichtungen zur Verfügung zu stellen, die den immer höheren Anforderungen an die mechanischen Eigenschaften, wie zum Beispiel Härte und Zähigkeit, tribologische Eigenschaften wie Adhäsionsneigung bei höheren Temperaturen sowie Reibung, die Oxidationsresistenz und anderen charakteristischen Eigenschaften, vor allem auch bei extremen Temperaturen gerecht zu werden.

Ausserdem sind die oben beschriebenen leistungsfähigeren Schichten verfahrenstechnisch sehr schwer herstellbar, und die damit beschichteten Werkzeuge sehr teuer sind, so dass sich vom Standpunkt der Wirtschaftlichkeit betrachtet, eine Beschichtung in vielen Fällen nicht lohnt, bzw. solcherart beschichtete Werkzeuge nur einen begrenzten Markt finden. Die Aufgabe der Erfindung ist es daher, ein verbessertes Schichtsystem für ein Substrat, insbesondere für ein Werkzeug oder ein Verschleissteil bereitzustellen, das die aus dem Stand der Technik bekannten Probleme überwindet, und insbesondere ein sich tribologisch positiv auswirkendes Oxidationsverhalten, eine höhere Phasenstabilität, sowie verbesserte mechanische Eigenschaften, vor allem, aber nicht nur, in Bezug auf die Härte aufweist und auch unter extremen Temperaturbedingungen einsetzbar ist.

Eine weitere Aufgabe der Erfindung ist es, eine Lichtbogenverdampfungsquelle bereitzustellen, mit der die neuen verbesserten Schichtsysteme hergestellt werden können.

Die diese Aufgaben lösenden Gegenstände der Erfindung sind durch die Merkmale der unabhängigen Ansprüche gekennzeichnet.

Die jeweiligen abhängigen Ansprüche beziehen sich auf besonders vorteilhafte Ausführungsformen der Erfindung.

Die Erfindung betrifft somit ein Schichtsystem zur Bildung einer Oberflächenschicht auf einer Oberfläche eines Substrats, insbesondere auf der Oberfläche eines Werkzeugs, wobei das Schichtsystem mindestens eine erste Hartschicht der Zusammensetzung (MₒSiₚAY_{q})(NᵣCₛOₜ) umfasst, mit (o+p+q+r+s+t), wobei 40 ≤ (o+p+q) ≤ 60 gilt, und wobei M mindestens ein Metall aus der Gruppe der chemischen Elemente bestehend aus den Elementen aus den Nebengruppen IVb, Vb, VIb des Periodensystems der Elemente ist. Erfindungsgemäss das Schichtsystem M und AY enthält und AY mindestens ein Element aus der Gruppe der chemischen Elemente bestehend aus den Elementen Sc, La, Ac und den Elementen der Gruppe der Lanthanoide des Periodensystems der chemischen Elemente ist, wobei AY bevorzugt zusätzlich Bor enthält.

Dabei ist die Komponente G durch (NᵣCₛOₜ) definiert und die Komponente A wird im folgenden zur besseren Unterscheidung mit AY bezeichnet.

Die gegenüber dem Stand der Technik erheblich verbesserte Leistungsfähigkeit der Werkzeuge und Bauteile wird somit erfindungsgemäss dadurch erreicht, dass die entsprechenden Substrate mit einer ersten Hartschicht der Zusammensetzung (MₒSiₚA_{q})G, also mit einer Schicht der Zusammensetzung (MₒSiₚAY_{q})(NᵣCₛOₜ) beschichtet werden, wobei G wie angegeben in an sich bekannter Zusammensetzung mindestens ein Element aus der Gruppe Stickstoff (N), Kohlenstoff (C) und Sauerstoff (O) ist, und M mindestens ein Metall aus der Gruppe der chemischen Elemente bestehend aus den Elementen aus den Nebengruppen IVb, Vb, VIb des Periodensystems der Elemente ist.

Die deutlich verbesserten Eigenschaften der erfindungsgemässen Schichtsysteme, vor allem in Bezug auf Härte, Druckeigenspannungen Oxidationsfestigkeit und Phasenstabilität bis hinauf zu Temperaturen von 1.200°C und mehr, konnten dadurch erreicht werden, dass ein weiteres Element A die chemische Zusammensetzung eines erfindungsgemässen Schichtsystems ergänzt, wobei A mindestens ein Element aus der Gruppe der chemischen Elemente bestehend aus Mangan (Mn), Eisen (Fe), Kobalt (Co), Nickel (Ni), Kupfer (Cu), und den Elementen der Nebengruppe IIIB, und den Elementen der Hauptgruppe IA, IIA, IIIA und den Elementen der Gruppe der Lanthanoide des Periodensystems der chemischen Elemente ergänzt wird. Bekanntermassen besteht dabei die Hauptgruppe Ia des Periodensystems der Elemente, aus den Elementen Wasserstoff (H), Lithium (Li), Natrium (Na), Kalium (K), Rubidium (Rb), Cäsium (Cs) und Francium (Fr), die Hauptgruppe IIa besteht aus den Elementen Beryllium (Be), Magnesium (Mg), Calcium (Ca), Strontium (Sr), Barium (Ba) und Radium (Ra), die Hauptgruppe IIIa besteht aus den Elemente Bor (B), Aluminium (Al), Gallium (Ga), Indium (In) und Thallium (TI), und die Nebengruppe Illb besteht aus den chemischen Elementen Scandium (Sc), Yttrium (Y), Lanthan (La) und Actinium (Ac).

Die Nebengruppen IVb, Vb, Vlb, aus denen neben Aluminium das Metall M für die Formeleinheit (MₖSiₗAₘ) auswählbar ist, bestehen aus den Elementen Titan (Ti), Zirkon (Zr), Hafnium (Hf) der Gruppe IVb, den Elementen Vanadium (V), Niob (Nb), Tantal (Ta) der Nebengruppe Vb, und Chrom (Cr), Molybdän (Mo) und Wolfram (W) der Nebengruppe Vlb des Periodensystems der Elemente.

Zu der Gruppe der Lanthanoide zählen bekanntermassen die chemischen Elemente Cer (Ce), Praseodym (Pr), Neodym (Nd), Promethium (Pm), Samarium (Sm), Europium (Eu), Gadolinium (Gd), Terbium (Tb), Dysprosium (Dy), Holmium (Ho), Erbium (Er), Thulium (Tm), Ytterbium (Yb) und Lutetium (Lu).

Als besonders vorteilhaft hat sich für die Komponente A die Verwendung mindestens eines Seltene Erden Elements herausgestellt. Die Gruppe der Seltenen Erden umfasst dabei bekanntermassen die Lanthanoide, sowie Lanthan, Scandium und Yttrium. Dabei sind die reinen Elemente aus der Gruppe der Seltenen Erden zwar in bestimmten Eigenschaften durchaus verschieden, z.B. in Bezug auf die Schmelz- und Verdampfungspunkte, den Dampfdruck usw., jedoch sind sich diese Elemente in Bezug auf ihre chemischen Eigenschaften eher sehr ähnlich als verschieden, was sich allein schon darin zeigt, dass ihre Trennung in der Praxis sehr grosse Schwierigkeiten bereitet.

Daher kommen sie häufig auch in Form von sogenannten Mischmetallen zum Einsatz, d.h., es werden z.B. für Zulegierungen nicht reine Metalle aus der Gruppe der Seltenen Erden verwendet, sondern bestimmte Mischungen die zwei oder mehrere Elemente aus der Gruppe der Seltenen Erden und möglicherweise auch weitere andere chemische Elemente in vorgebbaren Mengen enthalten. Dabei ist es bekannt, dass bereits die Zugabe sehr kleiner Mengen von Mischmetallen, je nach Zusammensetzung, die chemischen und physikalischen Eigenschaften einer Grundsubstanz massiv beeinflussen können.

Überraschender Weise hat sich nun gezeigt, dass die aus dem Stand der Technik bekannte Hartschichten, die die eingangs erwähnten Nachteile aufweisen, wie insbesondere mangelnde Oxidationsbeständigkeit und Phasenstabilität vor allem bei höheren Temperaturen, wie sie z.B. bei Hochleitungswerkzeugen im Betriebszustand sehr häufig auftreten, durch die Zugabe der Komponente AY in Form einer oder mehrerer Seltene Erde Elemente und / oder im speziellen eines oder mehrerer Elemente der Hauptgruppe IA, und / oder IIA und / oder IIIA diese Eigenschaften entscheidend verbessern lassen, wobei es durch geeignete Wahl der chemischen Zusammensetzungen durch die vorliegende Erfindung erstmals gelungen ist, Oxidationsbeständigkeit, Phasenbeständigkeit, Härte und andere entscheidende Grössen, wie z.B. die Haftfestigkeit und Druckeigenspannungen gleichzeitig zu optimieren.

Insbesondere hat sich gezeigt, dass sich die Schichten des erfindungsgemässen Schichtsystems auch vorteilhaft mit bereits bekannten Schichten und Schichtsystemen zu neuen Schichtsystemen kombinieren lassen, so dass durch die vorliegende Erfindung völlig neue Schichtsysteme mit im Vergleich zum Stand der Technik in fast jeder Hinsicht verbesserten Eigenschaften bereitgestellt werden. Auch die aus dem Stand der Technik bekannten konventionellen Schicht wie z.B. Schichten aus den klassischen Verbindungen wie TiN, TiNC, CrN und andere sind vorteilhaft, je nach Anforderungen, mit einer erfindungsgemässen ersten Hartschicht kombinierbar.

Das liegt insbesondere daran, dass durch eine geeignete erfindungsgemässe Auswahl der chemischen Elemente, die die Komponente AY in dem erfindunsgemässen Schichtsystem (MₒSiₚA_{q})G bildet, die Schichtsysteme eine enorme Flexibilität erreichen, da z.B. für die Komponente AY eine breite Auswahl an Atomdurchmessern zur Verfügung stehen, wodurch z.B. Gitterparameter angepasst werden können, ohne dabei die chemischen Bindungsmöglichkeiten negativ zu beeinflussen.

So können in einem erfindungsgemässen Schichtsystem verschiedenartige Schichten, die ganz unterschiedliche Funktionen haben können, hervorragend kombiniert werden, ohne dass z.B. Probleme mit der Haftfestigkeit zwischen den Schichten oder auf dem Substrat auftreten, und ohne dass sich z.B. durch ungewünschte Diffusionsvorgänge oder andere physikalisch chemische Reaktionen das erfindungsgemässe Schichtsystem mit der Zeit verschlechtert, oder bei hohen Temperaturen und grossen mechanischen Beanspruchungen im Betriebszustand versagt.

Auch können die Teilschichten mit der chemischen Zusammensetzung (MₒSiₚAY_{q})_{γ}(NᵣCₛOₜ)_{δ} eines erfindungsgemässen Schichtsystems durch geeignete Auwahl der chemischen Zusammensetzung der Komponente AY verschiedenste Funktionen übernehmen. So kann eine erfindungsgemässe (MₒSiₚAY_{q})_{γ}(NᵣCₛOₜ)_{δ}-Schicht z.B. in einem Fall eine Haftschicht sein, die eine hervorragende Haftung des gesamten Schichtsystem auf dem Substrat herstellt, indem sie z.B. die Gitterparameter des Substrats an das weitere Schichtsystem anpasst, oder indem die spezielle Chemie des Substrats an diejenige des weiteren Schichtsystem angeglichen wird.

Eine erfindungsgemässe (MₒSiₚAY_{q})_{γ}(NᵣCₛOₜ)_{δ}-Schicht kann aber auch z.B. in einer modifizierten chemischen Zusammensetzung in einem Schichtsystem eine Zwischenschicht mit den an sich bekannten Funktionen bilden oder aber auch eine deckende erste Hartschicht sein, die das Substrat, z.B. ein Werkzeug oder ein Verschleissteil, gegen thermische, mechanische und chemische Angriffe schützt.

Bei einem bevorzugten Ausführungsbeispiel kann die Komponente AY zusätzlich noch Bor (B) enthalten. Während Stickstoff (N) unter anderem wesentlich zur Härte des Schichtsystems beiträgt, und Silizium (Si) wesentlich für die Oxidationsbeständigkeit ist, kann durch die zusätzliche Verwendung von B die Beständigkeit des Gefüges gegen thermische Belastungen wesentlich verbessert werden.

Bevorzugt, aber nicht notwendig, ist der Anteil von Si im Schichtsystem auf einen Bereich von 0.04 ≤ p < 30 eingestellt, wobei im Rahmen dieser Anmeldung die durch Indizes an den chemischen Elementen bzw. an den die chemischen Elementen repräsentierenden Symbolen indizierten Mengen angaben durchweg Atomprozent (at-%) sind.

Das heisst, z.B. die Angabe 0.1 ≤ I < 50 mit (o+p+q)=100 bedeutet, dass Si in der Formeleinheit (MₒSiₚA_{q}) zwischen 10% Atomprozent (at-%) und 50%-Atomprozent (at-%) vertreten ist.

Durch die Einstellung des Siliziumgehalts auf den vorgenannten Bereich lässt sich z.B., aber nicht nur, gleichzeitig die Oxidationsbeständigkeit und die Zähigkeit bzw. Härte sowie die Druckeigenspannungen der Schicht in vorgebbaren Grenzen optimieren, bzw. zusätzlich zu anderen Massnahmen optimieren.

Der Anteil der chemischen Komponente A in der Formeleinheit (MₒSiₚAY_{q})_{γ}(NᵣCₛOₜ)_{δ} liegt dabei bevorzugt im Bereich 0.004 < q < 6 ist, wobei, wie bereits erwähnt natürlich auch diese Angaben als Atomprozent zu verstehen sind.

Durch die Wahl der Komponente AY im vorgenannten Bereich lassen sich, wie sich gezeigt hat, neben weiteren Parametern, die Phasenbeständigkeit auch bei sehr hohen Temperaturen, selbst oberhalb von 1200°C entscheidend verbessern, aber auch die Oxidationsbeständigkeit lässt sich dadurch massiv erhöhen, wobei gleichzeitig relevante Gitterparameter angepasst werden, so dass ein gewünschtes Eigenspannungsniveau der Schichten einstellbar ist und darüber hinaus die Härte des Schichtsystem weiter erhöhbar ist.

Wie bereits erwähnt, ist die Komponente AY bevorzugt, jedoch nicht notwendig, ein Element aus der Gruppe der Seltenen Erden, insbesondere ein Element aus der Gruppe der chemischen Elemente bestehend aus Y und den Lanthanoiden, insbesondere Ce und / oder La, was die weiter oben bereits ausführlich beschrieben Vorteile des erfindungsgemässen Schichtsystems bewirkt.

Wie bereits erwähnt kann AY auch ein Mischmetall umfassen, wobei sich gezeigt hat, dass die Verwendung von Mischmetallen als Bestandteil der chemischen Komponente AY dazu führen kann, dass bereits geringste Mengen an Mischmetallen die gewünschten Eigenschaften eines erfindungsgemässen Schichtsystems enorm beeinflussen können, ohne dass entsprechende gravierende Änderungen, z.B. in der chemischen Zusammensetzung oder in der Gitterstruktur in Kauf genommen werden müssen.

Dabei ist in der Literatur die Definition des "Mischmetalls" nicht ganz eindeutig. Im Rahmen der vorliegenden Anmeldung ist der Begriff des Mischmetalls jedenfalls in einer sehr breiten technischen Bedeutung zu verstehen.

In einer sehr engen Definition, die lediglich als spezielles Beispiel für ein bestimmtes Mischmetall zu verstehen ist und keinesfalls die Bedeutung des Begriffs Mischmetall für die vorliegende Anmeldung einschränkt, ist ein

Mischmetall, auch Cer-Mischmetall, eine Metall-Legierung aus Metallen der Seltenen Erden. Es besteht z.B. zu 45 % bis 52 % aus Cer, zu 20 % bis 27 % aus Lanthan, zu 15 % bis 18 % aus Neodym, zu 3 % bis 5 % aus Praseodym, und zu 1 % bis 3 % aus Samarium, Terbium und Yttrium, Spuren anderer Seltenerde-Metalle, Calcium und Silizium und bis zu 5 % aus Eisen.

Die Zusammensetzung kann sich beispielsweise unmittelbar aus der des Ausgangsminerals Monazit ergeben. Übersteigt der Eisenanteil 15 % (meist bis 50 %), spricht man häufig auch von Cer-Eisen.

Aufgrund der Ähnlichkeit der chemischen Eigenschaften der Seltenen Erden sind Abweichungen in der Zusammensetzung für bestimmte Eigenschaften unkritisch, während andere Eigenschaften sehr wohl durch eine Änderung der chemischen Zusammensetzung beeinflussbar sind.

Als Zusatz bei der Stahlherstellung können Mischmetalle unerwünschte Eisenoxide reduzieren, sie können Sauerstoff und Schwefel binden und die Entgasung unterstützen. Als Legierungsmetall können sie die Gieß- und Fließeigenschaften, sowie die Korrosionsbeständigkeit von Eisen-Chrom-Aluminium-Werkstoffen in heißen oxidierenden Gasen verbessern helfen.

Die folgende Tabelle 1 zeigt fünf weitere spezielle Beispiele von Mischmetallen, wobei die Definition des Begriffs "Mischmetall" für die Beispiele der Tabelle 1 deutlich weitergefasst ist. So umfassen die Mischmetalle der Tabelle 1 neben verschiedenen Seltenen Erden auch andere Beimischungen, und zwar sowohl Metalle, als auch Nichtmetalle wie Fe, Si, Mg, S, und Phosphor. Aber auch andere Elemente wie Hafnium (Hf), Kobalt (Co), Zirkon (Zr), Nickel (Ni) und weitere Elemente des Periodensystems können in einem Mischmetall vorhanden sein.

Aber wie bereits erwähnt, auch die Tabelle 1 ist für die Bedeutung des Begriffs Mischmetall im Rahmen dieser Anmeldung lediglich exemplarisch zu verstehen und wirkt in keiner Weise beschränkend für die Klasse der ganz verschiednen Mischmetalle, die in einem erfindungsgemässen Schichtsystem vorteilhaft von der Komponente AY umfasst sein können.

**Tabelle 1**

| | Mischmetall 1 | Mischmetall 2 | Mischmetall 3 | Mischmetall 4 | Mischmetall 5 |
|---|---|---|---|---|---|
| **La** | 25-33% | 25-34% | 25-34% | 30-40% | 44-50% |
| **Ce** | 48% min. | 48-55% | 48-55% | 60-70% | 50-56% |
| **Pr** | 4-7% | 4-6% | 4-6% | 0.5% max. | 0.1% max. |
| **Nd** | 11-15% | 14-17% | 14-17% | 0.5% max. | 0.1% max. |
| **Fe** | 0.5% max. | 0.2% max. | 0.5% max. | 0.5% max. | 0.5% max. |
| **Si** | 0.2% max. | 0.05% max. | 0.2% max. | 0.2% max. | 0.2% max. |
| **Mg** | 0.5% max. | 0.05% max. | 0.5% max. | 0.5% max. | 0.5% max. |
| **S** | 0.02% max. | 0.02% max. | 0.02% max. | 0.02% max. | 0.02% max. |
| **P** | 0.01% max. | 0.01% max. | 0.01% max. | 0.01% max. | 0.01% max. |

In ganz speziellen Fällen, wenn aus bestimmten Gründen z.B. die chemischen Elemente, die die Komponente AY bilden, eher kleinere Atomdurchmesser haben sollen, oder bestimmte chemische und / oder physikalische Randbedingungen zu erfüllen sind, kann die Komponente AY ausschliesslich nur aus Be und / oder nur aus Ca gebildet sein.

Dabei sind aus analogen oder ähnlichen oder anderen Gründen auch weitere Spezialfälle möglich. So kann AY in einem anderen Fall auch nur Sc und / oder Y und / oder La sein, und / oder AY kann nur mindestens ein Element aus der Gruppe der Lanthanoide sein, insbesondere nur Ce sein und sonst kein anderes Element umfassen.

Im Folgenden werden einige exemplarische Ausführungsbeispiele erfindungsgemässer Schichtsysteme diskutiert, die zur Bestimmung spezifischer Schichtparameter zunächst der Einfachheit halber als Einschichtsysteme hergestellt wurden. Es versteht sich, dass nicht nur die nachfolgenden Schichtsysteme sondern insbesondere alle im Rahmen dieser Anmeldung präsentierten Ausführungsbeispiele auch vielfältig vorteilhaft kombinierbar sind.

In einem ersten Ausführungsbeispiel wurde eine TiSiN-Schicht untersucht, die in einem erfindungsgemässen Ausführungsbeispiel einen Anteil eines Cer-Mischmetalls enthält.

Die Schicht wurde in an sich bekannter Weise mittels einer Lichtbogenverdampfungsquelle in einer entsprechenden, dem Fachmann ebenfalls wohl bekannten Prozesskammer aufgebracht. Eine verwendete Lichtbogenverdampfungsquelle, oft auch einfach Kathode genannt, hat im vorliegenden Beispiel einen Durchmesser von 100mm und bis auf technisch unwesentliche Verunreinigungen die folgende chemische Zusammensetzung: 82.5at-% Ti, 17%at-% Si, 0.5%at-% Cer-Mischmetall (Ce_{M}), wobei das Cer-Mischmetall zu 54%-Gewichtsprozent aus Ce, zu 29%- Gewichtsprozent aus La, zu 13%- Gewichtsprozent aus Nd und zu 4%- Gewichtsprozent aus Pr besteht.

Zur Beschichtung wurde ein Substrat, im vorliegenden Fall ein Schnellarbeitsstahl, in der Prozesskammer zunächst auf ca. 500°C aufgeheizt, ionengereinigt und anschliessend bei einem Gasdruck von ungefähr 5Pa, bei einem Kathodenstrom von ca. 130A und einer Vorspannung von ca. 50V beschichtet.

Zum Vergleich wurde unter den gleichen Beschichtungsbedingungen eine aus dem Stand der Technik bekannte AlTiN-Schicht hergestellt, wobei eine Kathode mit 55%-Atomprozent Al und 45%-Atomprozent Ti verwendet wurde.

Der notwendige Stickstoff wurde für beide Schichten über das Prozessgas in der Prozesskammer zur Verfügung gestellt.

Die folgende Tabelle 2 stellt die wichtigsten Schichteigenschaften der so erzeugten beiden Schichten vergleichend gegenüber. Dabei bedeutet in Tabelle 2 Ce_{M} ein wie zuvor definiertes Cer-Mischmetall.

**Tabelle 2**

| | AlTiN | TiSiCe_{M}N |
|---|---|---|
| Mikrohärte Knoop [HK0.025] | 2226 | 4093 |
| Verschleissrate [m²/(Nm)] | 8.09 | 3.59 |

Die Mikrohärte gemäss Tabelle 2 wurde dabei in bekannter Weise nach der Methode von Knoop bestimmt und die Verschleissrate über den Abrasionswiderstand mit einem KALOTEST N Gerät der Firma BAQ mit einem Kugeldurchmesser von 30mm und 540 Wellenumdrehungen bei 60U/min unter Verwendung einer Schleifemulsion.

Die Tabelle 2 demonstriert in beeindruckender Weise eine fast doppelt so grosse Härte und eine weniger als halb so grosse Verschleissrate der erfindungsgemässen TiSiCe_{M}N-Schicht, im Vergleich zu der aus dem Stand der Technik bekannten AlTiN-Schicht.

In Röntgenbeugungsuntersuchungen konnte dabei bei den erfindungsgemässen Schichten eine eindeutig bevorzugte (200)-Orientierung des Gitters beobachtet werden, während (111)-Orientierungen praktisch nicht zu beobachten waren.

In einem weiteren, für die Praxis sehr wichtigen Ausführungsbeispiel umfasst ein erfindungsgemässes Schichtsystem mindestens eine zusätzliche zweite Hartschicht der Zusammensetzung (AlₐMg_{b}Cr_{c}Me_{d}BₑAₘSiₖ)G mit (a+b+c+d+e+m+k) = 100, wobei G mindestens ein Element aus der Gruppe der chemischen Elemente bestehend aus N, C und O ist. Me ist mindestens ein Element aus der Gruppe der chemischen Elemente bestehend aus den Nebengruppen IVb, Vb und VIb des Periodensystems der chemischen Elemente, und A ist mindestens ein Element aus der Gruppe der chemischen Elemente bestehend aus den Elementen der Hauptgruppen Ia, IIa, und den Elementen der Nebengruppen VIIb, VIIIb, Ib, IIb, IIIb, und den Elementen der Gruppe der Lanthanoide des Periodensystems der Elemente, wobei 0.01 ≤ m < 100 und 1 ≤ a ≤ 97 und 0.1 ≤ b ≤ 20 und 30 ≤ c ≤ 70 ist.

Etwas genauer gesagt kann das erfindungsgemässe Schichtsystem mindestens eine zusätzliche zweite Hartschicht der Zusammensetzung (AlₐMg_{b}Cr_{c}Me_{d}BₑAXₘSiₖ)_{α}(NᵤCᵥO_{w})_{β} umfassen, mit (a+b+c+d+e+m+k) = α, (u+v+w) = β, und (α+β) =100, wobei 40 ≤α ≤ 60 gilt, und wobei Me mindestens ein Element aus der Gruppe der chemischen Elemente bestehend aus den Nebengruppen IVb, Vb und Vlb des Periodensystems der chemischen Elemente ist. AX ist dabei mindestens ein Element aus der Gruppe der chemischen Elemente bestehend aus den Elementen der Hauptgruppen la und den Elementen Be, Ca, Sr, Ba und den Elementen der Nebengruppen VIIb, VIIIb, Ib, IIb, IIIb und den Elementen der Gruppe der Lanthanoide des Periodensystems der Elemente, wobei 0.004 ≤ m < 60, bevorzugt 0.01 ≤ m < 50 ist, und 0.4 ≤ a ≤ 58 und 0.04 ≤ b ≤ 12 und 18 ≤ c ≤ 42 ist. Diese Darstellung gilt unter der Bedingung, dass (a+b+c+d+e+m+k) = α und nicht (a+b+c+d+e+m+k) = 100 wie in der Formulierung (AlₐMg_{b}Cr_{c}Me_{d}BₑAₘSiₖ)G.

Diese etwas spezifischere Formulierung erhält man durch Ersetzung des Symbols G durch (NᵤCᵥO_{w})_{β} unter Berücksichtigung dass die Komponente A zur besseren Unterscheidung im folgenden mit AX bezeichnet wird.

Die gegenüber dem Stand der Technik erheblich verbesserte Leistungsfähigkeit der Werkzeuge und Bauteile wird somit zusätzlich dadurch erreicht, dass die entsprechenden Substrate mit einer zusätzlichen zweiten Hartschicht der Zusammensetzung (AlₐMg_{b}Cr_{c}Me_{d}BₑAₘSiₖ)G, genauer mit einer zusätzlichen Hartschicht der Zusammensetzung (AlₐMg_{b}Cr_{c}Me_{d}BₑAXₘSiₖ)_{α}(NᵤCᵥO_{w})_{β} beschichtet werden, wobei G wie angegeben in an sich bekannter Zusammensetzung mindestens ein Element aus der Gruppe Stickstoff (N), Kohlenstoff (C) und Sauerstoff (O) ist, und Me mindestens ein Metall aus der Gruppe der chemischen Elemente bestehend aus den Elementen aus den Nebengruppen IVb, Vb, VIb des Periodensystems der Elemente ist, und A mindestens ein Element aus der Gruppe der chemischen Elemente bestehend aus, den Elementen der Hauptgruppen Ia, IIa, und den Elementen der Nebengruppen VIIb, VIIIb, Ib, IIb, IIIb, und den Elementen der Gruppe der Lanthanoide des Periodensystems der Elemente ist.

Dadurch können vor allem für spezielle Erfordernisse und Anwendungen die Eigenschaften der erfindungsgemässen Schichtsysteme, insbesondere in Bezug auf Härte, Druckeigenspannungen Oxidationsfestigkeit und Phasenstabilität bis hinauf zu Temperaturen von 1.200°C und mehr, weiterhin deutlich verbessert werden, was insbesondere dadurch erreicht wird, dass in der zweiten Hartschicht der Anteil an Aluminium (Al) auf 0.4 ≤ a ≤ 58 beschränkt ist, und gleichzeitig der Anteil an Magnesium (Mg) auf 0.04 ≤ b ≤ 12 und der Anteil an Chrom (Cr) auf 18 ≤ c ≤ 42 beschränkt ist. Die Nebengruppe Ib besteht aus den chemischen Elementen Kupfer (Cu), Silber (Ag), Gold (Au) und Terbium (Tb), die Nebengruppe IIb besteht aus den chemischen Elementen Zink (Zn), Cadmium (Cd), Quecksilber (Hg) und Dysprosium (Dy).

Die weiteren Nebengruppen VIIb und VIIIb, aus denen die Komponente AX der Formeleinheit (AlₐMg_{b}Cr_{c}Me_{d}BₑAXₘSiₖ) ebenfalls ausgewählt sein kein, bestehen aus den chemischen Elementen Mangan (Mn), Technetium (Tc), Rhenium (Re) der Nebengruppe VIIb, und Eisen (Fe), Ruthenium (Ru), Osmium(Os), Kobalt (Co), Rhodium (Rh), Iridium (Ir), Nickel (Ni), Palladium (Pd) und Platin (Pt) der Nebengruppe VIIIb des Periodensystems der chemischen Elemente.

Überraschender Weise hat sich nun gezeigt, dass sich ein erfindungsgemässes Schichtsystem mit einer ersten Hartschicht, durch Kombination mit einer zweiten Hartschicht, die die oben angegebene Einschränkung des Aluminium-, Magnesium- und Chromgehalts in der Verbindung (AlₐMg_{b}Cr_{c}Me_{d}BₑAXₘSiₖ)G entscheidend verbessern lassen, wobei es durch geeignete Wahl der chemischen Zusammensetzungen durch die vorliegende Erfindung erstmals gelungen ist, Oxidationsbeständigkeit, Phasenbeständigkeit, Härte, Druckeigenspannung und andere entscheidende Grössen, wie z.B. die Haftfestigkeit gleichzeitig in einer (AlₐMg_{b}Cr_{c}Me_{d}BₑAXₘSiₖ)G - Schicht durch Kombination einer ersten Hartschicht mit einer zweiten Hartschicht gemäss der vorliegenden Erfindung noch weiter zu verbessern und zu optimieren.

Auch die Teilschichten gebildet aus einer zweiten Hartschicht mit der chemischen Zusammensetzung (AlₐMg_{b}Cr_{c}Me_{d}BₑAₘSiₖ)G bzw. (AlₐMg_{b}Cr_{c}Me_{d}BₑAXₘSiₖ)ₐ(NᵤCᵥO_{w})_{β} eines erfindungsgemässen Schichtsystems können durch eine geeignete konkrete Auswahl des Al-, Mg- und Chromgehalts verschiedenste Funktionen übernehmen. So kann eine zweite (AlₐMg_{b}Cr_{c}Me_{d}BₑAXₘSiₖ)_{α}(NᵤCᵥO_{w})_{β}-Hartschicht z.B. in einem Fall eine Haftschicht sein, die eine hervorragende Haftung des gesamten Schichtsystem auf dem Substrat herstellt, indem sie z.B. die Gitterparameter des Substrats an das weitere Schichtsystem anpasst, oder indem die spezielle Chemie des Substrats an diejenige des weiteren Schichtsystem angeglichen wird.

Eine zweite (AlₐMg_{b}Cr_{c}Me_{d}BₑAXₘSiₖ)_{α}(NᵤCᵥO_{w})_{β}-Hartschicht kann aber auch z.B. in einer modifizierten chemischen Zusammensetzung in einem Schichtsystem eine Zwischenschicht mit den an sich bekannten Funktionen bilden oder aber auch eine deckende erste Hartschicht sein, die das Substrat, z.B. ein Werkzeug oder ein Verschleissteil, gegen thermische, mechanische und chemische Angriffe schützt.

In einem für die Praxis wichtigen Beispiel ist die Komponente AX ein Mischmetall.

Als besonders vorteilhaft zur Bildung eines Mischmetalls als Komponente AX hat sich dabei die Verwendung mindestens eines Seltene Erden Elements herausgestellt.

Dabei hat sich gezeigt, dass auch die Eigenschaften der zweiten (AlₐMg_{b}Cr_{c}Me_{d}BₑAXₘSiₖ)_{α}(NᵤCᵥO_{w})_{β} -Hartschicht bereits durch die Zugabe sehr kleiner Mengen von Mischmetallen, je nach Zusammensetzung, die chemischen und physikalischen Eigenschaften der zweiten Hartschicht massiv beeinflussen kann.

Vorteilhaft wird in einer zweiten Hartschicht der Anteil von Aluminium (Al) im Bereich von 20 ≤ a ≤ 42, und der Anteil an Magnesium (Mg) im Bereich von 0.02 ≤ b ≤ 6 gewählt. Es hat sich insbesondere gezeigt, dass die Wahl des Al und Mg Anteils im vorgenannten Bereich zu einem guten Kompromiss bei der Optimierung von Oxidations- und Phasenbeständigkeit, bei gleichzeitiger Erhöhung von Härte, Druckeigenspannung und Zähigkeiten einer zweiten (AlₐMg_{b}Cr_{c}Me_{d}BₑAXₘSiₖ)_{α}(NᵤCᵥO_{w})_{β} -Hartschicht führt, wobei darüber hinaus auch gute tribologische Eigenschaften erzielbar sind.

Die Metalle Me aus den Nebengruppen IVb und / oder Vb und / oder VIb sind bevorzugt in einer Menge entsprechend 4 ≤ d ≤ 54 in einer zweiten Hartschicht vorhanden. Durch diese Wahl der Zusammensetzung lässt sich eine weitere Steigerung der Härte eines erfindungsgemässen Schichtsystems erreichen, wobei durch geeignete Wahl der konkreten Zusammensetzung der Metallgruppe Me, abhängig von der Anwendung der Beschichtung, eine Optimierung der Nitridbildung in einer zweiten Hartschicht erreichbar ist.

Im Speziellen ist Si in einer Menge von höchstens k = 24 in der zweiten Hartschicht vorhanden. Während Stickstoff (N) unter anderem wesentlich zur Härte der zweiten Hartschicht und damit des gesamten Schichtsystems beiträgt, und Silizium (Si) wesentlich für die Oxidationsbeständigkeit ist, führt die zusätzliche Verwendung von Bor (B) dazu, dass die Beständigkeit des Gefüges gegen thermische Belastungen wesentlich verbessert ist.

Durch die Einstellung des Siliziumgehalts auf den vorgenannten Bereich lässt sich z.B., aber nicht nur, gleichzeitig die Oxidationsbestaändigkeit und die Zähigkeit bzw. Härte der Schicht in bestimmten Grenzen weiter optimieren, bzw. zusätzlich zu anderen Massnahmen optimieren.

In ganz speziellen Fällen, wenn aus bestimmten Gründen z.B. die chemischen Elemente, die die Komponente AX bilden, eher kleinere Atomdurchmesser im Bereich der zweiten Hartschicht wünschenswert ist, oder bestimmte chemische Randbedingungen zu erfüllen sind, kann die Komponente AX der zweiten Hartschicht ausschliesslich nur aus Li und / oder aus Be und / oder aus Ca und / oder aus Si gebildet sein.

Dabei sind aus ähnlichen oder analogen oder anderen Gründen auch weitere Spezialfälle möglich. So kann die Komponente AX der zweiten Hartschicht in einem anderen Fall auch nur Sc und / oder nur Y und / oder nur La sein, oder AX kann nur mindestens ein Element aus der Gruppe der Lanthanoide ist, insbesondere nur Ce sein und sonst kein anderes Element umfassen.

Im Folgenden werden einige exemplarische Ausführungsbeispiele erfindungsgemässer Schichtsysteme mit einer zweiten Hartschicht diskutiert, die zur Bestimmung spezifischer Schichtparameter zunächst der Einfachheit halber als Einschichtsysteme der zweiten Hartschicht hergestellt wurden. Es versteht sich, dass nicht nur die nachfolgenden Schichtsysteme sondern insbesondere alle im Rahmen dieser Anmeldung präsentierten Ausführungsbeispiele auch vorteilhaft kombinierbar sind.

In einem ersten Ausführungsbeispiel wurde eine AlCrMgSiN-Schicht untersucht.

Diese zweite Hartschicht wurde in an sich bekannter Weise mittels einer Lichtbogenverdampfungsquelle in einer entsprechenden, dem Fachmann ebenfalls wohl bekannten Prozesskammer aufgebracht. Eine verwendete Lichtbogenverdampfungsquelle, oft auch einfach Kathode genannt, hat einen Durchmesser von 100mm und bis auf technisch unwesentliche Verunreinigungen die folgende chemische Zusammensetzung: 68at-% Al, 29.5at-% Cr, 1.5%at-% Mg und 1at-% Si.

Die Zusammensetzung der aufgebrachten Schicht wurde sodann folgendermassen bestimmt:
REM: LEO, EDX: INCA, Beschleunigungsspannung 15keV.

Diese Untersuchung ergab die folgende Zusammensetzung der auf das Substrat aufgebrachten Schicht: 64.03at-% Al, 33.93at-%Cr, 1.08at-% Si und 0.96at-% Mg.

Zur Beschichtung wurde ein Substrat, im vorliegenden Fall eine Schnellarbeitsstahl, in der Prozesskammer zunächst auf ca. 500°C aufgeheizt, ionengereinigt und anschliessend bei einem Gasdruck von ungefähr 6.5Pa, bei einem Kathodenstrom von ca. 150A und einer Vorspannung von ca. 50V gepulst beschichtet.

Zum Vergleich wurde eine aus dem Stand der Technik bekannte AlTiN-Schicht hergestellt, wobei eine Kathode mit 55%-Atomprozent Al und 45%-Atomprozent Ti verwendet wurde.

Der notwendige Stickstoff wurde für beide Schichten über das Prozessgas in der Prozesskammer zur Verfügung gestellt.

Die folgende Tabelle 3 stellt die wichtigsten Schichteigenschaften der so erzeugten beiden Schichten vergleichend gegenüber.

**Tabelle 3**

| | AlTiN | AlCrMgSiN |
|---|---|---|
| Mikrohärte Knoop [HK0.025] | 2500 | 2850 |
| Verschleissrate [m²/(Nm)] | 2.9 | 1.9 |
| Oberflächenwiderstand [Ohm] | 10 | 27.250 |

Die Mikrohärte gemäss Tabelle 3 wurde dabei in bekannter Weise nach der Methode von Knoop bestimmt und die Verschleissrate über den Abrasionswiderstand mit einem KALOTEST mit kaloMAX NT der Firma BAQ mit einem Kugeldurchmesser von 30mm und 540 Wellenumdrehungen bei 60U/min unter Verwendung einer Schleifemulsion. Der Oberflächenwiderstand wurde mit einem Multimeter bei einem Abstand zwischen den Messspitzen von ca. 10mm gemessen.

Die Tabelle 3 demonstriert in beeindruckender Weise eine deutlich grössere Härte und eine um ca. 1/3 reduzierte Verschleissrate der als AlCrMgSiN - Schicht ausgebildeten zweiten Hartschicht, im Vergleich zu der aus dem Stand der Technik bekannten AlTiN-Schicht. Bemerkenswert ist der enorm hohe Oberflächenwiderstand der AlCrMgSiN-Schicht der vorliegenden Erfindung, der fast 3000 mal grösser, als derjenige der bekannten AlTiN-Schicht ist, was ein erfindungsgemässes Schichtsystem mit einer zweiten Hartschicht vor allem für Einsatzbereiche besonders interessant macht, in welchen unbedingt das Fliessen von elektrischen Strömen, z.B. von Oberflächenströmen oder von Strömen innerhalb des Schichtsystems verhindert bzw. reduziert werden muss bzw. die Entstehung von magnetischen und elektrischen Feldern aufgrund von elektrischen Strömen unterdrückt bzw. verhindert werden muss. Somit ist ein erfindungsgemässes Schichtsystem mit einer zweiten Hartschicht insbesondere auch für Anwendungen besonders gut geeignet, wo entsprechende elektromagnetische, insbesondere dielektrische Eigenschaften des Schichtsystems eine Rolle spielen.

Wie bereits erwähnt, kann in einem bevorzugten Ausführungsbeispiel eines erfindungsgemässen Schichtsystems die erste Hartschicht eine abschliessende Deckschicht des Schichtsystems sein, während in einem anderen Ausführungsbeispiel die zweite Hartschicht eine abschliessende Deckschicht des Schichtsystems bildet.

Im speziellen kann ein erfindungsgemässes Schichtsystem eine Funktionsschicht, insbesondere eine Verbundschicht, bevorzugt eine Verbundschicht aus MetₓE_{y}N_{z}, mit x > 0; y ≥ 0 und z > 0 umfassen, wobei Met mindestens ein Metall aus der Gruppe Al, Cr, Mo, W, V,Nb, Ta, Ti, Zr, HF, Mn, Fe; Co; Ni, Li, Be, Mg, Sc, Y, La, Ce, Nd, Sm ist und E ein Element aus der Gruppe Si, B, C, O ist.

Dabei kann z.B. eine Zwischenschicht umfassend die Elemente Si und / oder C vorgesehen sein und / oder es ist eine Gradienten-Mischschicht vorgesehen, die die Elemente Si und / oder C der Zwischenschicht und die Zusammensetzung (MₒSiₚAY_{q})_{γ}(NᵣCₛOₜ)_{δ} der ersten Hartschicht und / oder die Zusammensetzung (AlₐMg_{b}Cr_{c}Me_{d}BₑAXₘSiₖ)_{α}(NᵤCᵥO_{w})_{β} der zweiten Hartschicht umfasst.

Im speziellen kann in der Funktionsschicht der Anteil der metallischen Komponenten der Schicht minimiert sein bzw. ganz fehlen, so dass als Funktionsschicht Si/B dominierende Schichten zusätzlich in einem erfindungsgemässen Schichtsystem vorgesehen sind.

Bedingt durch die komplizierte Herstellung ist dabei zu SiBx Keramiken bisher noch relativ wenig bekannt. Es liegen zum Beispiel folgende Angaben für SiB₆ Volumenmaterialien vor orthorhombisches Gitter, Härte ca. 2600 , Elastizitätsmodul 290 GPa, Dichte 2,43 g/cm³, thermischer Ausdehnungskoeffizient 4,6 *10⁻⁶/ °C, Wärmeleitfähigkeit 9 W/mK, Schmelzpunkt 1950 °C. Insbesondere ist die hohe Oxidationsbeständigkeit hervorzuheben: stabil in Luft bis 1550 °C.

Diese Stabilität von SiBx Keramiken bei hohen Temperaturen wird von den klassischen Schichtsystemen wie AlTiN, AlCrSiN und TiSiN nicht erreicht. Dabei sind solche Volumeneigenschaften in ähnlicher Form bei Schichten des Typs SiBx hinsichtliche der Härten und der Oxidationseigenschaften zu finden, wobei die Darstellung dieser Schichten mittels der PVD-Beschichtung industrielle Relevanz hat.

Der Mechanismus des Oxidationsschutzes der SiBx-Funktionsschichten beruht dabei auf der Ausbildung einer Doppelschicht des Types SiO/BO. Die entstehende äußere Si-reiche Schicht verhindert die Sauerstoffdiffusion in die Schicht.

Es wurde daher bereits vorgeschlagen, die neue Beschichtungs-Materialklasse SiBx, insbesondere speziell die neue Beschichtungs-Materialklasse SiBCN als Beschichtungsmaterial für Werkzeuge einzusetzen.

Insbesondere weil sich gezeigt hat, dass eine Funktionsschicht auf der Basis von SiB-Verbindungen, bzw. von SiBNC in Kombination mit den bekannten klassischen Hartstoffschichten ebenfalls zu den deutlich verbesserten Schichteigenschaften führt, wird mit der vorliegenden Erfindung vorgeschlagen, derartige Funktionsschichten, falls notwendig, ebenfalls in ein Schichtsystem der vorliegenden Erfindung zu integrieren.

Je nach Anforderung an die zu beschichtenden Substrate bzw. Werkzeuge kann es im Speziellen besonders vorteilhaft sein, die Funktionsschichten in einem erfindungsgemässen Schichtsystem mit Sauerstoff zu dotieren, und so zum Beispiel zu SiBNCO-Schichten zu gelangen, die unter anderem durch Voroxidation bzw. durch Verfeinerung der Struktur der Schichten die Diffusion von Sauerstoff reduzieren und die Oxidationsbeständigkeit auch bei hohen Temperaturen massiv erhöhen.

Die Dotierung mit Sauerstoff der Funktionsschicht führt darüber hinaus zu einer Belegung der Korngrenzen mit Sauerstoff, so dass zumindest bei einer partiellen Ausbildung der oben genannten oder anderer Doppelschichtsysteme die Neigung zu Strukturumwandlung in den Schichtsystemen, die oftmals eine mehr oder weniger offene Porosität bzw. Schichtdefekte aufweisen, reduziert wird, da durch die Dotierung mit Sauerstoff eine Voroxidation eingeleitet wird.

Gemäss der vorliegenden Erfindung ist es dabei entscheidend, dass die Funktionsschichten mindestens die beiden Elemente Si und B aufweisen, insbesondere damit sich schützende Doppelschichten ausbilden können. Das heisst, ein erfindungsgemässes Schichtsystem kann mindestens eine Funktionsschicht der Zusammensetzung SiₐB_{b}Me_{c}NᵤCᵥO_{w} mit a,b > 0 und 33at-% > c ≥ 0 und u,v,w ≥ 0,wobei Me ein Metall ist, dass im Speziellen z.B. ein für die Targetherstellung zur Abscheidung der erfindungsgemäßen Schicht verwendetes Metall z.B. Al bei SiC, oder aber ein gezielt eingebautes metallisches Element sein kann.

Die Funktionsschichten eines erfindungsgemässen Schichtsystems können dabei vorzugsweise auf geeigneten metallischen Zwischenschichten aber auch auf Si, SiC Zwischenschichten, sowie auf einer ersten Hartschicht oder auf einer zweiten Hartschicht gemäss der vorliegenden Erfindung abgeschieden werden, sowie direkt auf metallischen oder keramischen Werkzeugmaterialien oder vorzugsweise auf mit Hartstoffschichten beschichteten Werkzeugmaterialien abgeschieden werden.

Bevorzugt, aber nicht notwendig, liegen die Funktionsschichten eines erfindungsgemässen Schichtsystems in einem weitgehend amorphen Zustand vor, wobei in einem speziellen Ausführungsbeispiel eine Ausbildung von nanokristallinen Bereichen in den Funktionsschichten vorliegen kann.

Die Schichtdicken der Funktionsschichten liegen dabei im Bereich zwischen ca. 5 nm - 50 000 nm, im Speziellen zwischen 10 nm und 2500 nm, vorzugsweise zwischen (100 - 500) nm und können als Unterschicht z.B. Al-Basishartstoffschichten abgeschieden in gleichen oder in getrennten Anlagen umfassen.

Die metallische Komponente Me einer Funktionsschicht ist dabei mindestens ein Metall aus der Gruppe Al, Cr, Mo, W, V,Nb, Ta, Ti, Zr, HF, Mn, Fe; Co; Ni, Li, Be, Mg, Sc, Y, La, Ce, Nd, Sm.

Bei einem besonders bevorzugten Ausführungsbeispiel ist auf der Oberfläche des Substrats mindestens eine Verbundschicht, bevorzugt eine Verbundschicht aus MeₓE_{y}N_{z}, mit x,y ≥ 0 und z > 0 vorgesehen, wobei Me mindestens ein Metall aus der Gruppe Al, Cr, Mo, W, V,Nb, Ta, Ti, Zr, HF, Mn, Fe; Co; Ni, Li, Be, Mg, Sc, Y, La, Ce, Nd, Sm und E ein Element aus der Gruppe bestehend aus Si, B, C, O ist.

Für spezielle Anwendungen kann ein spezielles erfindungsgemässes Schichtsystem auch eine Zusatzhartschicht aus SiₐB_{b}Me_{c}NᵤCᵥO_{w}, insbesondere eine Zusatzhartschicht aus SiₐB_{b}Me_{c}CᵥNᵤ, im speziellen eine Zusatzhartschicht aus SiₐB_{b}CᵥNᵤ vorgesehen sein.

In einem besonders bevorzugten Ausführungsbeispiel ist eine AlTi-Hartschicht mit der Zusammensetzung (Al_{1-α-β}Ti_{α}X_{β}) (N_{1-γ}C_{γ}O_{δ}B_{ε}), mit 0.2 < α < 0.6, 0 ≤ β < 0.2 und α+β > 0.01 und 0 ≤ γ < 0.5, 0 ≤ δ < 0.5, 0 ≤ ε < 0.5 und γ+δ+ε > 0.01, wobei X ein Element der Gruppe bestehend aus Zr, V, Cr, Nb, Ta; W; Mo; Hf, Mg Si, Y ist.

Die Funktionsschichten auf der Basis von SiB werden im Bereich der atomaren Zusammensetzung von Si:B im Bereich von 9 bis 0.1 abgeschieden, wobei die verschiedensten Zusammensetzungen innerhalb einer Gradientenschicht bzw. mehrlagigen Schicht darstellbar sind. Bevorzugt werden Bor-reiche Funktionsschichen abgeschieden, d. h: der Si Gehalt ist kleiner als der Borgehalt. Insbesondere ist die Zusammensetzung mit 6 Boaratomen pro Si-Atom interessant, da sich zumindest lokal die besonders stabile SiB6-Struktur in den Funktionsschichten ausbilden kann.

Die Zuführung von N,C;O führt zur Ausbildung verschiedenster Bindungszustände in den Funktionsschichten, so treten B-N, B-C, Si-N ,Si-C, Si-O, B-O Bindungen auf, die sich jedoch nur aufwendig quantifizieren lassen. Die kovalenten Bindungsanteile (z.B SiN und BC) bewirken eine hohe Härte. Der strukturelle Mechanismus und der Bindungsmechanismus dieser komplexen Schichten ist beim gegenwärtigen Stand des Wissens nur unzureichend, um Voraussagen über die komplexen Schichteigenschaften zu treffen.

In einer bevorzugten Ausführungsform sollte die atomare Zusammensetzung der Funktionsschichtenten im Verhältnis aus ca. gleichen Anteilen von Si und Bor und N bzw. Mischungen aus N,C,O bestehen. Es ist aber auch eine überstöchiometrische Zusammensetzung hinsichtlich des N und C-Gehaltes bezogen auf SiB anstrebenswert, die jedoch herstelltechnisch problematisch ist. Beispielsweise wäre eine solche Schichtzusammensetzung ca. gleiche Anteile von Si, B und C jedoch ca. einen N-Anteil, der das dreifache des Si-Anteiles beträgt entsprechend der Volumenkeramiken sinnvoll.

Bei den oben beschriebenen bevorzugten Zusammensetzungen der Funktionsschichten können sich zumindest lokal hochstabile Verbindungen ausbilden - in Form von Si₃B₃N₇ oder SiBN₃C.

Die Sauerstoffgehalte in den Funktionsschichten werden deutlich unter 50 at-% vorzugsweise um 10 at-% bezogen auf die Gesamtzusammensetzung begrenzt, da der ionische Bindungsanteil, der in der Regel zu sprödem Materialverhalten führt begrenzt werden sollte.

Metallanteile in den Funktionsschichten werden sinnvoll ebenfalls mit deutlich unter 50 at-% eingestellt, wobei diese meist - außer in den Zwischenschichten - auf maximal 10 at-% beschränkt sind. Diese Anteile dienen dabei als Bindungsbrücken zur untereren Hartstoffschicht bzw. entstammen aus den Targetbindemitteln.

Die Härten der Funktionsschichten überstreichen dabei den Bereich von ca. 1000 bis 5000 Vickers, bevorzugt zwischen 2000 und 3500 Vickers. Die Auswahl der geeigneten Schicht richtet sich dabei nach den jeweiligen tribologischen Eigenschaften. Beispielsweise ist für verschiedene Mikrowerkzeuge die Reibung aussschlagebend, um Überhitzungen zu vermeiden, so dass reibungsmindernde Boroxide wünschenswert sind, wobei schon Schichthärten um 1000 Vickers sinnvoll sein können. Es kommt auf eine tribologische Trennschicht an. In Anwesenheit von Luftfeuchtigkeit wandelt sich das Boroxid zu Borsäure um, wodurch niedrige Reibwerte erreichbar sind.

Bei Kugelfräsern im Kontakt zu Ti-Legierungen sollte hingegen ein hohes Härteniveau eingestellt werden.

Nicht nur, aber auch zur Verbesserung der Hafteigenschaften auf dem Substrat bzw. auf einer anderen Schicht des erfindungsgemässen Schichtsystems, zum Beispiel auf einem besonders stark beanspruchten Werkzeug, kann eine Zwischenschicht umfassend die Elemente Si und / oder C vorgesehen sein.

Darüber hinaus kann in einem weiteren Ausführungsbeispiel eine Gradienten-Mischschicht vorgesehen sein, die die Elemente Si und / oder C der Zwischenschicht und die Zusammensetzung SiₐB_{b}Me_{c}NᵤCᵥO_{w}, insbesondere SiₐB_{b}Me_{c}CᵥNᵤ, im speziellen SiₐB_{b}CᵥNᵤ der ersten Hartschicht umfasst. Die Zusammensetzung der Gradienten-Mischschicht kann sich dabei mehr oder weniger kontinuierlich von der Zusammensetzung einer ersten Schicht, mit der die Gradienten-Mischschicht in Kontakt ist, zu der Zusammensetzung einer zweiten Schicht, mit der die Gradienten-Mischschicht ebenfalls in Kontakt ist, ändern, so dass die erste und die zweite Schicht, die zum Beispiel verschiedene chemische und / oder physikalische Eigenschaften, wie Gitterstruktur, Kristallinität, thermische Ausdehnung usw. haben können, optimal aufeinander anpassbar.

Besonders vorteilhaft ist eine Sauerstoff-Funktionsschicht aus SiₐB_{b}MeNᵤCᵥO_{w}, im speziellen eine SiₐB_{b}NᵤCᵥO_{w} Sauerstoff-Funktionsschicht vorgesehen, die insbesondere als Deckschicht vorgesehen sein kann. Diese Deckschicht kann zum Beispiel, aber nicht nur die Diffusion von Sauerstoff in die Schicht unterbinden oder minimieren, dadurch unter anderem die Oxidationsfestigkeit erhöhen. Ausserdem kann die Deckschicht dem Schichtsystem gegen Angriffe von aussen, besondere chemische, thermische und mechanische Eigenschaften verleihen, so dass das erfindungsgemässe Schichtsystem durch die Deckschicht zum Beispiel besonders gut gegen die hohe Temperatur geschützt ist und / oder besonders vorteilhafte mechanische Eigenschaften, oder besonders gute tribologische Eigenschaften aufweisen. Es versteht sich, dass die zuvor beschriebenen Ausführungsbeispiele der Erfindung, je nach Anwendung, auch in jeder geeigneten Weise kombinierbar sind und insbesondere die exemplarisch dargestellten Schichtabfolgen auch in anderer Weise realisiert sein können und eine oder mehrere der Schichten in einem speziellen Ausführungsbeispiel eines erfindungsgemässen Schichtsystems ganz fehlen können oder in einem anderen Ausführungsbeispiel in ein und demselben Schichtsystem auch mehrfach vorkommen können.

Im Speziellen kann dabei eine Schichtdicke der Verbundschicht und / oder der Zwischenschicht und / oder der ersten Hartschicht und / oder der zweiten Hartschicht und / oder der Gradienten-Mischschicht zwischen 0.1 µm und 50 µm, insbesondere zwischen 1 µm und 15 µm, vorzugsweise zwischen 5 µm und 8 µm liegt.

Eine Härte HK0.05 der ersten Hartschicht und / oder der zweiten Hartschicht liegt bevorzugt zwischen 10 GPa und 50 GPA, insbesondere zwischen 25 GPa und 35 GPa und eine Druckeigenspannung der ersten Hartschicht und / oder der zweiten Hartschicht liegt zwischen 0.1 GPa und 10 GPA, insbesondere zwischen 1.5 GPa und 4 GPa.

Eine Oxidationsbeständigkeit und / oder eine Phasenstabilität eines erfindungsgemässen Schichtsystems ist dabei bis zu Temperaturen grösser als 700°C, insbesondere bis zu Temperaturen grösser als 1.000°C gewährleistet.

Zum Aufbringen eines erfindungsgemässen Schichtsystems betrifft die Erfindung weiterhin eine erste Lichtbogenverdampfungsquelle mit einem Verdampfungsmaterial als Kathode zur Erzeugung einer Oberflächenschicht auf einer Oberfläche eines Substrats durch Verdampfung des Verdampfungsmaterials mittels einer Lichtbogenentladung auf einer Verdampfungsoberfläche der Kathode. Dabei hat das Verdampfungsmaterial eine chemische der Zusammensetzung (Al_{a'}Mg_{b'}Cr_{c'}Me_{d'}B_{e'}AX_{m'}Si_{k'}), mit (a'+b'+c'+d'+e'+m'+k') = 100, und wobei Me mindestens ein Element aus der Gruppe der chemischen Elemente bestehend aus den Nebengruppen IVb, Vb und VIb des Periodensystems der chemischen Elemente ist. AX ist mindestens ein Element aus der Gruppe der chemischen Elemente bestehend aus den Elementen der Hauptgruppen Ia, IIa und den Elementen der Nebengruppen VIIb, VIIIb, Ib, IIb, IIIb und den Elementen der Gruppe der Lanthanoide des Periodensystems der Elemente, wobei 0.01 ≤ m' < 100, bevorzugt 0.012≤ m' < 80 ist. Erfindunggemäss ist dabei der Gehalt an Al, Mg und Cr auf 1 ≤ a ≤ 97 und 0.1 ≤ b ≤ 20 bzw. 30 ≤ c ≤ 70 beschränkt.

In einem speziellen Ausführungsbeispiel enthält die Lichtbogenverdampfungsquelle zusätzlich C und / oder N und / oder O, wobei in einem für die Praxis besonders wichtigen Ausführungsbeispiel die Komponente AX ein Mischmetall sein kann.

Im Speziellen liegt der Aluminiumgehalt im Bereich 50 ≤ a' ≤ 70 ist und der Magnesiumgehalt ist auf einen Bereich 0.5 ≤ b' ≤ 10 beschränkt.

Bevorzugt, aber nicht notwendig, ist Me in einer Menge entsprechend 10 ≤ d' ≤ 80 in der Lichtbogenverdampfungsquelle vorhanden, und der Gehalt an Si beträgt höchstens k' = 40 in einer Kathode der vorliegenden Erfindung.

Im Speziellen ist die Komponente AX nur Li und / oder Be und / oder Ca und / oder Si, und / oder AX ist nur Sc und / oder Y und / oder La, wobei in einem anderen Ausführungsbeispiel AX nur mindestens ein Element aus der Gruppe der Lanthanoide ist, insbesondere nur Ce ist.

Die Erfindung betrifft weiterhin eine zweite Lichtbogenverdampfungsquelle mit einem Verdampfungsmaterial als Kathode zur Erzeugung einer Oberflächenschicht auf einer Oberfläche eines Substrats durch Verdampfung des Verdampfungsmaterials mittels einer Lichtbogenentladung auf einer Verdampfungsoberfläche der Kathode, wobei das Verdampfungsmaterial eine chemische Zusammensetzung (M_{o'}Si_{p'}AY_{q'}) ist, mit (o'+p'+q') = 100, und wobei M mindestens ein Metall aus der Gruppe der chemischen Elemente bestehend aus Al und den Elementen aus den Nebengruppen IVb, Vb, VIb des Periodensystems der Elemente ist. Die Komponente AY der zweiten Lichtbogenverdampfungsquelle ist dabei mindestens ein Element aus der Gruppe der chemischen Elemente bestehend aus Mn, Fe, Co, Ni, Cu, und den Elementen der Nebengruppe IIIB, und den Elementen der Hauptgruppe IA, IIA und IIIA, und den Elementen der Gruppe der Lanthanoide des Periodensystems der chemischen Elemente.

In einem bevorzugten Ausführungsbeispiel kann die zweite Lichtbogenverdampfungsquelle zusätzlich C und / oder N und / oder O enthalten und / oder die Komponente AY enthält zusätzlich Bor (B).

Bevorzugt ist dabei 0.1 ≤ p' < 50 und / oder es gilt die Bedingung 0.01 < q' < 10.

In einem für die Praxis besonders wichtigen Ausführungsbeispiel ist die Komponente AY der zweiten Verdampfungsquelle ein Mischmetall und / oder AY ist ein Element aus der Gruppe der chemischen Elemente bestehend aus Y und den Lanthanoiden, insbesondere Ce und / oder La ist.

Im speziellen kann die Komponente AY der zweiten Verdampfungsquelle nur Be und / oder Ca sein und / oder AY kann in einem anderen Ausführungsbeispiel nur Sc und / oder Y und / oder La sein.

In einem speziellen aber wichtigen Fall ist AY nur mindestens ein Element aus der Gruppe der Lanthanoide, insbesondere kann die Komponente AY nur aus Ce bestehen.

Darüber hinaus betrifft die Erfindung auch Kombinations-Verdampfungsquelle mit einem Verdampfungsmaterial bestehend aus einem Verdampfungsmaterial der ersten Verdampfungsquelle und der zweiten Verdampfungsquelle.

Schliesslich betrifft die Erfindung auch ein Substrat, insbesondere eine Werkzeug, das mit einem Schichtsystem gemäss der vorliegenden Erfindung beschichtet ist.

Ein erfindungsgemässes Werkzeug kann dabei ein Urformwerkzeug, ein Presswerkzeug, ein spanendes Werkzeug, insbesondere ein Bohrer, ein Fräser, eine Wendeschneidplatte für einen Dreh- oder Fräsprozess oder ein Hobelwerkzeug, ein Umformwerkzeug oder ein Mikrowerkzeug, insbesondere ein Mikrobohrer, eine Mikrowendeschneidplatte, ein Mikrofräser oder ein anderes Werkzeug oder Mikrowerkzeug oder ein Kunststoffwerkzeug sein. Ein erfindungsgemäss beschichtetes Substrat kann darüber hinaus auch ein Verschleissteil, insbesondere ein Verschleissteil für eine Luft- oder Land gestützte Turbine, einen Motor, im Speziellen für einen Verbrennungsmotor, im speziellen eine Dichtung, ein Zahnrad, ein Kolben ein Kolbenring, ein Verschleissteil für eine Textilmaschine oder ein anderes Verschleissteil ist.

## Patentansprüche

1. Schichtsystem zur Bildung einer Oberflächenschicht auf einer Oberfläche eines Substrats, insbesondere auf der Oberfläche eines Werkzeugs, wobei das Schichtsystem mindestens eine erste Hartschicht der Zusammensetzung (MₒSiₚAY_{q})(NᵣCₛOₜ) umfasst, mit (o+p+q+r+s+t) = 100, wobei 40 ≤ (o+p+q)≤ 60 gilt, und wobei M mindestens ein Metall aus der Gruppe der chemischen Elemente bestehend aus:
- den Elementen aus den Nebengruppen IVb, Vb, VIb
des Periodensystems der Elemente ist,
**dadurch gekennzeichnet, dass** das Schichtsystem M und AY enthält und AY mindestens ein Element aus der Gruppe der chemischen Elemente bestehend aus:
- den Elementen Sc, La, Ac und
- den Elementen der Gruppe der Lanthanoide
des Periodensystems der chemischen Elemente ist, wobei AY bevorzugt zusätzlich Bor enthält,
wobei 0.04 ≤ p < 30 ist.

2. Schichtsystem nach Anspruch 1, wobei 0.004 < q < 6 ist.

3. Schichtsystem nach einem der vorangehenden Ansprüche, wobei die erste Hartschicht eine abschliessende Deckschicht des Schichtsystems ist.

4. Schichtsystem nach einem der vorangehenden Ansprüche, wobei auf der Oberfläche des Substrats mindestens eine weitere Funktionsschicht vorgesehen ist.

5. Schichtsystem nach Anspruch 4, wobei die Funktionsschicht eine Verbundschicht aus MetₓE_{y}N_{z}, mit x > 0; y ≥ 0 und z > 0 ist, wobei Met mindestens ein Metall aus der Gruppe Al, Cr, Mo, W, V,Nb, Ta, Ti, Zr, HF, Mn, Fe; Co; Ni, Li, Be, Mg, Sc, Y, La, Ce, Nd, Sm ist und E ein Element aus der Gruppe Si, B, C, O ist.

6. Schichtsystem nach einem der vorangehenden Ansprüche, wobei eine Zwischenschicht umfassend das Element Si vorgesehen ist.

7. Schichtsystem nach einem der vorangehenden Ansprüche, wobei eine Zwischenschicht umfassend das Element C vorgesehen ist.

8. Schichtsystem nach einem der Ansprüche 6 oder 7, wobei eine Gradienten-Mischschicht vorgesehen ist, die das Element Si der Zwischenschicht und die Zusammensetzung (MₒSiₚAY_{q})(NᵣCₛOₜ) der ersten Hartschicht umfasst.

9. Substrat, beschichtet mit einem Schichtsystem nach einem der vorangehenden Ansprüche.

## Claims

1. A layer system for the formation of a surface layer on a surface of a substrate, in particular on the surface of a tool, wherein the layer system comprises at least one first hard layer of the composition (MₒSiₚAY_{q})(NᵣCₛOₜ) with (o+p+q+r+s+t) = 100, wherein 40 ≤ (o+p+q) ≤ 60 and wherein M is at least one metal of the group of the chemical elements consisting of:
- the elements of the subgroups IVb, Vb, VIb
of the periodic table of the elements,
**characterized in that** the layer system contains M and AY, and AY is at least an element of the group of the chemical elements consisting of:
- the elements Sc, La, Ac and
- the elements of the group of the lanthanoids
of the periodic table of the elements, AY preferably also containing boron, wherein 0.04 ≤ p < 30.

2. A layer system according to claim 1, wherein 0.004 < q < 6.

3. A layer system according to anyone of the preceding claims, wherein the first hard layer is a final top layer of the layer system.

4. A layer system according to anyone of the preceding claims, wherein at least another functional layer is provided on the surface of the substrate.

5. A layer system according to claim 4, wherein the functional layer is a composite layer consisting of MetₓE_{y}N_{z}, with x > 0; y ≥ 0 and z > 0, wherein Met is at least one metal of the group Al, Cr, Mo, W, V, Nb, Ta, Ti, Zr, HF, Mn, Fe; Co; Ni, Li, Be, Mg, Sc, Y, La, Ce, Nd, Sm and E is an element of the group Si, B, C, O.

6. A layer system according to anyone of the preceding claims, wherein an intermediate layer is provided comprising the element Si.

7. A layer system according to anyone of the preceding claims, wherein an intermediate layer is provided comprising the element C.

8. A layer system according to anyone of the claims 6 or 7, wherein a gradient mixed layer is provided comprising the element Si of the intermediate layer and the composition (MₒSiₚAY_{q})(NᵣCₛOₜ) of the first hard layer.

9. A substrate, which is coated with a layer system according to anyone of the preceding claims.

## Revendications

1. Système de couches pour la formation d'une couche superficielle sur une surface d'un substrat, en particulier sur la surface d'un outil, le système de couche comprenant au moins une première couche dure ayant la composition (MₒSiₚAY_{q})(NᵣCₛOₜ) avec (o+p+q+r+s+t) = 100, avec 40 ≤ (o+p+q) ≤ 60, et M étant au moins un métal du groupe des éléments chimiques consistant en :
- les éléments des groupes secondaires IVb, Vb, VIb
du tableau périodique des éléments,
**caractérisé en ce que** le système de couches contient M et AY, et AY est au moins un élément du groupe des éléments chimiques consistant en :
- les éléments Sc, La, Ac et
- les éléments du groupe des lanthanoïdes
du tableau périodique des éléments chimiques, AY contenant de préférence aussi du bore,
avec 0.04 ≤ p < 30.

2. Système de couches selon la revendication 1, avec 0.004 < q < 6.

3. Système de couches selon l'une des revendications précédentes, dans lequel la première couche dure est une couche supérieure finale du système de couches.

4. Système de couches selon l'une des revendications précédentes, dans lequel au moins une autre couche fonctionnelle est prévue sur la surface du substrat.

5. Système de couches selon la revendication 4, dans lequel la couche fonctionnelle est une couche composite consistant en MetₓE_{y}N_{z}, avec x > 0; y ≥ 0 et z > 0, dans lequel Met est au moins un métal du groupe Al, Cr, Mo, W, V, Nb, Ta, Ti, Zr, HF, Mn, Fe; Co; Ni, Li, Be, Mg, Sc, Y, La, Ce, Nd, Sm et E est un élément du groupe Si, B, C, O.

6. Système de couches selon l'une des revendications précédentes, dans lequel une couche intermédiaire est prévue comprenant l'élément Si.

7. Système de couches selon l'une des revendications précédentes, dans lequel une couche intermédiaire est prévue comprenant l'élément C.

8. Système de couches selon l'une des revendications 6 ou 7, dans lequel une couche mixte à gradient est prévue, comprenant l'élément Si de la couche intermédiaire et la composition (MₒSiₚAY_{q})(NᵣCₛOₜ) de la première couche dure.

9. Substrat qui est revêtu d'un système de couches selon l'une des revendications précédentes.
